# EUROPEAN PATENT SPECIFICATION

(11) **EP 3 001 786 B1**
(45) Date of publication and mention of the grant of the patent: **08.08.2018**
(21) Application number: 15186847.8
(22) Date of filing: 25.09.2015
(51) Int. Cl.: H02S 40/42, H05K 7/20

(54) **INVERTER HEAT-DISSIPATION DEVICE AND INVERTER**
WECHSELRICHTER WÄRMEABFUHRVORRICHTUNG UND WECHSELRICHTER
DISPOSITIF DE DISSIPATION DE CHALEUR D'ONDULEUR ET ONDULEUR

(30) Priority: 28.09.2014 CN 201410508020
(43) Date of publication of application: 30.03.2016
(73) Proprietor: Sungrow Power Supply Co., Ltd., Hefei, Anhui 230088 (CN)
(72) Inventor: LU, You, 230088 Hefei Anhui (CN); ZHOU, Jie, 230088 Hefei Anhui (CN); WANG, Nengfei, 230088 Hefei Anhui (CN); LI, Guohong, 230088 Hefei Anhui (CN)
(74) Representative: Brevalex

(56) References cited:
- EP-A1- 2 424 054
- EP-A1- 2 722 877
- CN-A- 103 687 456
- US-A- 5 485 350

## Description

### FIELD

The present disclosure relates to the technical field of inverter, and in particular to an inverter heat-dissipation device and an inverter.

### BACKGROUND

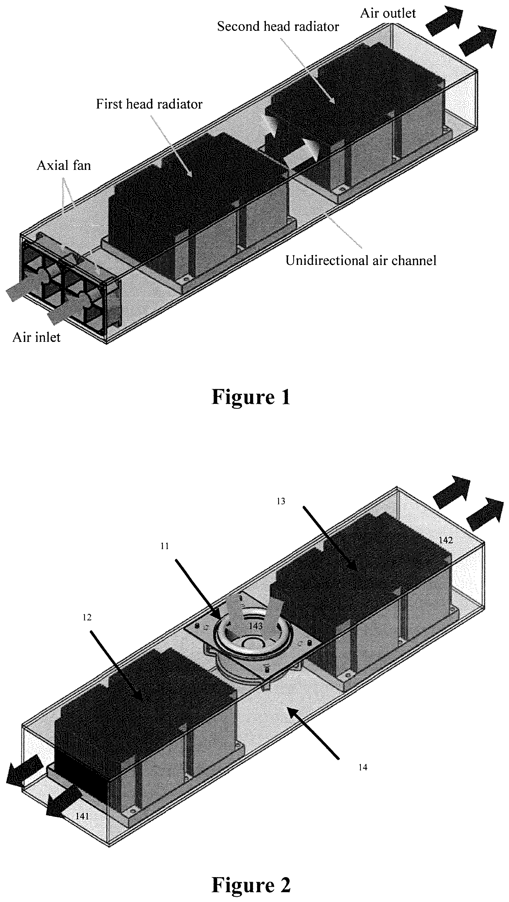

An air-cooled inverter generally dissipates heat via a unidirectional straight-through air channel which has an air inlet at one end and an air outlet at the other end as shown in Figure 1. An axial fan is located at the air inlet of the air channel. Cold air is blown into the air channel by the axial fan and flows through a first heat radiator and a second heat radiator for heat exchange. After the heat exchange, hot air flows out through the air outlet of the air channel, thereby achieving "the pulling-air cooling". Practically, the axial fan may be located at the air outlet of the air channel, for achieving "the drawing-air cooling".

Since at least two heat radiators are provided in the unidirectional straight-through air channel, a length of the unidirectional straight-through air channel (a distance from the air inlet to the air outlet) is long, which results in a great pressure loss along the unidirectional straight-through air channel and a heavy load on the fan, thereby reducing a life service of the fan.

The heat radiators in the unidirectional straight-through air channel are located at an upstream position and a downstream position in a flowing direction of an air flow. Air flowing through the upstream heat radiator is cold air, and most of air flowing through the downstream heat radiator is hot air discharged from the upstream heat radiator. Thus, the downstream heat radiator does not dissipate heat well. As the hot air continuously flows through the downstream heat radiator, heat-dissipation effect of the downstream heat radiator becomes increasingly worse and a temperature of the downstream heat radiator itself becomes increasingly higher, thereby resulting in a great difference between temperatures of the downstream heat radiator and the upstream heat radiator, and reducing the performance of an inverter including the heat radiator.

In patent EP2722877A1, a semiconductor element cooling structure includes a side wall (22) provided on a downstream side of flow of cooling air in a cooling air passage (31), a plurality of cooling fins (43) forming cooling air branch passages (41), and a plurality of cooling fins (53) forming cooling air branch passages (51). The cooling fins (43, 53) each have an end portion (43p, 53p) at a tip extending toward the cooling air passage (31). A virtual line (61) obtained by connecting the end portions (43p) of the plurality of cooling fins (43) and a virtual line (71) obtained by connecting the end portions (53p) of the plurality of cooling fins (53) each have a gradient with respect to a direction of the flow of the cooling air in the cooling air passage (31) which is greater on an upstream side of the flow of the cooling air in the cooling air passage (31) than on the downstream side thereof.

In patent US5485350A, a housing may hold a control device equipped with heat-producing components. A die-cast housing includes a side wall, a rear wall, a bottom, a cover, a front strut, a cooling element and an air guide device, a cover plate and a front cover. The cooling ribs of the cooling element run parallel to the rear wall, end in the plane of the side wall, and are covered with a bulkhead plate. The bottom and the cover are each provided with perforations for removing heat from the front housing half and openings through which connection lines may be passed. The front strut serves as a lateral frame part for the removable cover plate that covers a lateral access opening of the housing, and for the front cover which can close off the front-side opening of the housing. This results in a housing for a control device in book size format, where the number of assembly parts, the assembly effort and the assembly time are significantly reduced.

In patent CN103687456A, the invention discloses a high-efficiency heat dissipation wall-mounted inverting control all-in-one machine which comprises a waterproof case and a boosting radiator, a boosting transformer, an inverting radiator, a power supply radiator, a power supply boosting radiator and a rectification radiator which are arranged in the case. One end of the waterproof case is provided with two air inlet fans and a wiring terminal and the other end of the waterproof case is transversely provided with a buffer air duct; both ends of the buffer air duct are provided with air outlets; the side wall of the buffer air duct is provided with three induced draft fans; and the position in the waterproof case and close to the buffer air duct is provided with an air deflector. Due to adoption of the structural form, the problem of the requirements on a high protection grade and high heat exchange is solved. The machine adopts and uses the small-scale radiators, is low in cost, has a small complete machine space and can further meet the requirement on heat dissipation performance; integral waterproofness of the case is adopted; and meanwhile, air inlets and the air outlets are requested to have large air volumes, so that the high-efficiency heat dissipation wall-mounted inverting control all-in-one machine can meet the requirements of the radiators and other heat emitting devices inside on heat dissipation.

In patent EP2424054A1, the blower 20 is arranged in the lower portion of the power conditioner 3, the heat sink 19 is arranged such that there are clearances between the side surfaces of the heat sink 19 and the side plates 11a and 11b and moreover the heat sink 19 is arranged such that there is a clearance between the upper end portion of the heat sink 19 and the top plate 13, and the exhaust openings 17a and 17b formed in the side plates 11a and 11b are arranged to communicate with the clearances between the side surfaces of the heat sink 19 and the side plates 11a and 11b.

### SUMMARY

In order to solve the above technical problems, an inverter heat-dissipation device and an inverter are provided according to embodiments of the present disclosure, for extending a service life of a centrifugal fan, solving a problem of poor heat-dissipation effect of a heat radiator due to hot air flowing through the heat radiator, and improving the performance of an inverter including the heat radiator.

An inverter heat-dissipation device is provided, which includes a centrifugal fan, a first heat radiator, a second heat radiator and an air channel, where
a first air outlet is arranged at one end of the air channel and a second air outlet is arranged at the other end of the air channel;
the first heat radiator is arranged in the air channel and is in communication with the first air outlet;
the second heat radiator is arranged in the air channel and is in communication with the second air outlet;
the centrifugal fan is arranged in the air channel and is arranged between the first heat radiator and the second heat radiator;
an air inlet matching the centrifugal fan in size is arranged on the air channel;
a first opening is arranged on the air channel, where a first heating element of an inverter including the inverter heat-dissipation device is installed onto the first heat radiator through the first opening; and
a second opening is arranged on the air channel, where a second heating element of the inverter including the inverter heat-dissipation device is installed onto the second heat radiator through the second opening.

Preferably, the air channel may include an air channel backboard and a U-shaped groove, and the air channel backboard may be installed onto the U-shaped groove.

Preferably, the first heat radiator and the second heat radiator may be installed fixedly at different points on the air channel backboard; and the centrifugal fan may be installed fixedly on the U-shaped groove.

Preferably, the inverter heat-dissipation device may include:
a third air outlet and a fourth air outlet, where
the third air outlet may be arranged on a first lateral surface of the air channel and may match the centrifugal fan in size; and
the fourth air outlet may be arranged on a second lateral surface of the air channel opposite to the first lateral surface and may match the centrifugal fan in size.

An inverter is provided, which includes a first heating element, a second heating element and the inverter heat-dissipation device described above, where
the first heating element is installed onto the first heat radiator of the inverter heat-dissipation device via the first opening arranged on the air channel of the inverter heat-dissipation device; and
the second heating element is installed onto the second heat radiator of the inverter heat-dissipation device via the second opening arranged on the air channel of the inverter heat-dissipation device.

Preferably, the first heating element may be installed onto a first heat radiator substrate via the first opening arranged on the air channel of the inverter heat-dissipation device, where the first heat radiator substrate may be a radiator substrate of the first heat radiator; and
the second heating element may be installed onto a second heat radiator substrate via the second opening arranged on the air channel of the inverter heat-dissipation device, where the second heat radiator substrate may be a radiator substrate of the second heat radiator.

Preferably, a heat conduction silicone may be coated on a contact surface between the first heating element and the first heat radiator substrate; and
a heat conduction silicone may be coated on a contact surface between the second heating element and the second heat radiator substrate.

Preferably, the inverter may further include:
a third heating element and a fourth heating element, where
the third heating element may be arranged above the third air outlet of the inverter heat-dissipation device; and
the fourth heating element may be arranged below the fourth air outlet of the inverter heat-dissipation device.

Preferably, the inverter may further include:
a first row of air vents facing the third heating element; and
a second row of air vents facing the fourth heating element.

As compared with the conventional technology, the present disclosure has benefit effects hereinafter.

In the present disclosure, the centrifugal fan is disposed between the two heat radiators, the first heat radiator is in communication with the first air outlet, the second heat radiator is in communication with the second air outlet, and air is drawn in at the middle portion of the air channel and flows out from two ends of the air channel. Hence, a length of the air channel (i.e., a distance from the air inlet to the air outlet) is shortened; and a width of the air channel is increased since the air flows out through the two air outlets of the air channel simultaneously, thereby reducing a pressure loss along the air channel, reducing a load on the centrifugal fan, and extending a service life of the centrifugal fan.

Since the air is drawn in at the middle portion of the air channel and flows out from two ends of the air channel, the air flowing through each of the two heat radiators in the air channel is cold air, and a problem of poor a heat-dissipation effect of the heat radiator due to the hot air flowing through the heat radiator is solved. Problems of too high a temperature of the heat radiator itself and thus increasingly worse heat-dissipation effect due to the hot air continuously flowing through the heat radiator in the air channel are solved, and hence a difference between temperatures of the two heat radiators in the air channel is not too significant, thereby improving the performance of the inverter including the heat radiator.

### BRIEF DESCRIPTION OF THE DRAWINGS

The appended drawings to be used in the description of the embodiments will be described briefly as follows, so that the technical solutions according to the embodiments of the present disclosure will become clearer. It is obvious that the appended drawings in the following description only illustrate some embodiments of the present disclosure. For those skilled in the art, other appended drawings may be obtained according to these appended drawings without any creative work.
Figure 1 is a schematic structural diagram of a unidirectional straight-through air channel according to the conventional technology;
Figure 2 is a schematic structural diagram of an inverter heat-dissipation device according to the present disclosure;
Figure 3 is another schematic structural diagram of an inverter heat-dissipation device according to the present disclosure;
Figure 4 is still another schematic structural diagram of an inverter heat-dissipation device according to the present disclosure;
Figure 5 is a schematic sectional view of an inverter according to the present disclosure;
Figure 6 is a schematic structural diagram of an inverter according to the present disclosure; and
Figure 7 is another schematic structural diagram of an inverter according to the present disclosure.

### DETAILED DESCRIPTION OF THE EMBODIMENTS

The technical solution according to the embodiments of the present disclosure will be described clearly and completely as follows in conjunction with the appended drawings. Apparently, the described embodiments are only a few rather than all of the embodiments according to the present disclosure. Any other embodiments obtained by those skilled in the art based on the embodiments in the present disclosure without any creative work fall in the scope of protection of the present disclosure.

### First Embodiment

Reference is made to Figure 2, which shows a schematic structural diagram of an inverter heat-dissipation device according to the present disclosure. The inverter heat-dissipation device includes a centrifugal fan 11, a first heat radiator 12, a second heat radiator 13 and an air channel 14.

A first air outlet 141 is arranged at one end of the air channel 14, and a second air outlet 142 is arranged at the other end of the air channel 14.

The first heat radiator 12 is arranged in the air channel 14 and is in communication with the first air outlet 141.

The second heat radiator 13 is arranged in the air channel 14 and is in communication with the second air outlet 142.

The centrifugal fan 11 is arranged in the air channel 14 and is arranged between the first heat radiator 12 and the second heat radiator 13.

An air inlet 143 matching the centrifugal fan 11 in size is arranged on the air channel 14.

A first opening is arranged on the air channel 14, where a first heating element of an inverter including the inverter heat-dissipation device is installed onto the first heat radiator 12 through the first opening.

A second opening is arranged on the air channel 14, where a second heating element of the inverter including the inverter heat-dissipation device is installed onto the second heat radiator 13 through the second opening.

In an embodiment, the centrifugal fan 11 is arranged in the air channel 14 and is arranged between the first heat radiator 12 and the second heat radiator 13. The first heat radiator 12 is arranged at one end of the air channel 14, and the second heat radiator 13 is arranged at the other end of the air channel 14. After being drawn into the air channel 14 by the centrifugal fan 11, the cold air flows to the left and right through the first heat radiator 12 and the second heat radiator 13 respectively, and then flows out of the air channel through the air outlet 141 and the air outlet 142.

In the present disclosure, the centrifugal fan is disposed between the two heat radiators, the first heat radiator is in communication with the first air outlet, the second heat radiator is in communication with the second air outlet, and air is drawn in at the middle portion of the air channel and flows out from two ends of the air channel. Hence, a length of the air channel (i.e., a distance from the air inlet to the air outlet) is shortened; and a width of the air channel is increased since the air flows out through the two air outlets of the air channel simultaneously, thereby reducing a pressure loss along the air channel, reducing a load on the centrifugal fan, and extending a service life of the centrifugal fan.

Since the air is drawn in at the middle portion of the air channel and flows out from two ends of the air channel, the air flowing through each of the two heat radiators in the air channel is cold air, and a problem of poor a heat-dissipation effect of the heat radiator due to the hot air flowing through the heat radiator is solved. Problems of too high a temperature of the heat radiator itself and thus increasingly worse heat-dissipation effect due to the hot air continuously flowing through the heat radiator in the air channel are solved, and hence a difference between temperatures of the two heat radiators in the air channel is not too significant, thereby improving the performance of the inverter including the heat radiator.

Furthermore, with the inverter heat-dissipation device according to the present disclosure, the pressure loss along the air channel is reduced, the requirement for a configuration of the centrifugal fan 11 is reduced, and hence the centrifugal fan 11 with higher cost-effectiveness may be selected, thereby reducing a cost of the centrifugal fan 11.

In an embodiment, the air channel 14 includes an air channel backboard 144 and a U-shaped groove 145.

The air channel backboard 144 is installed onto the U-shaped groove 145.

In a case that the air channel 14 is composed of the air channel backboard 144 and the U-shaped groove 145, the centrifugal fan 11, the first heat radiator 12 and the second heat radiator 13 in the inverter heat-dissipation device shown in Figure 2 are arranged as follows.

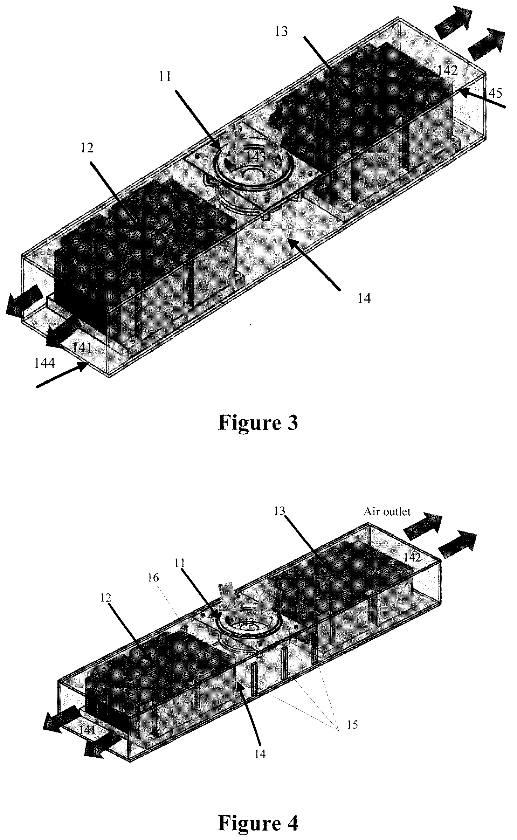

The first heat radiator 12 and the second heat radiator 13 are installed fixedly at different points on the air channel backboard 144, and the centrifugal fan 11 is installed fixedly on the U-shaped groove 145, as shown in Figure 3.

In an embodiment, the inverter heat-dissipation device further includes a third air outlet 15 and a fourth air outlet 16, as shown in Figure 4.

The third air outlet 15 is arranged on a first lateral surface of the air channel 14 and matches the centrifugal fan 11 in size.

The fourth air outlet 16 is arranged on a second lateral surface of the air channel 14 opposite to the first lateral surface and matches the centrifugal fan 11 in size.

In a case that the inverter heat-dissipation device is installed on the inverter, the third air outlet 15 and the fourth air outlet 16 are configured to blow and cool heating elements other than the first heating element and the second heating element.

### Second Embodiment

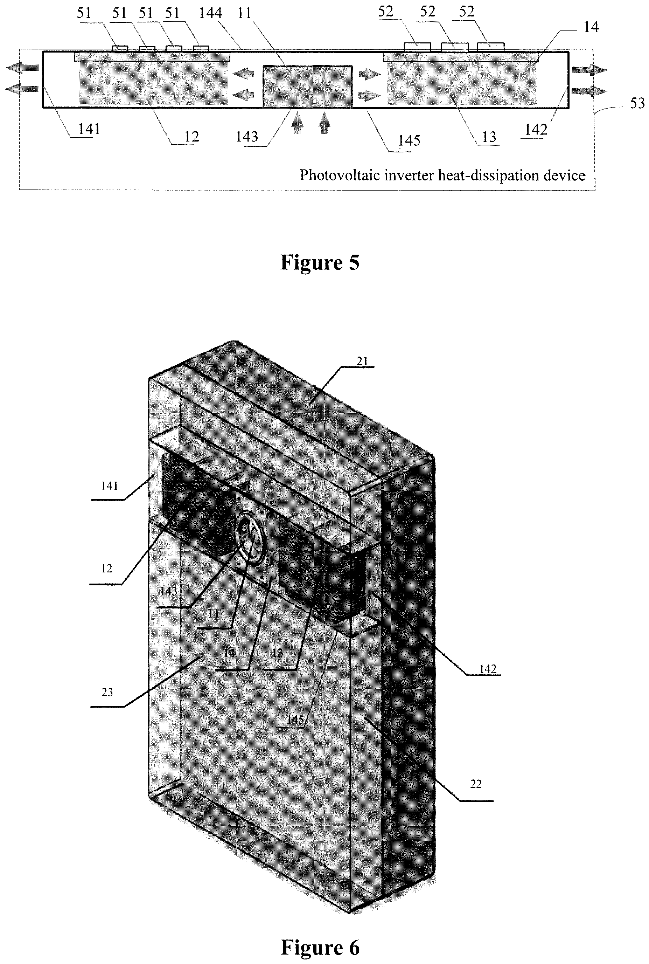

In an embodiment of the present disclosure, an inverter is provided. Reference is made to Figure 5, which shows a schematic sectional view of an inverter according to the present disclosure. The inverter includes a first heating element 51, a second heating element 52 and an inverter heat-dissipation device 53.

The inverter heat-dissipation device 53 is the inverter heat-dissipation device described in the first embodiment, which is not described here.

The first heating element 51 is installed onto the first heat radiator 12 of the inverter heat-dissipation device 53 via the first opening arranged on the air channel 14 of the inverter heat-dissipation device 53.

The second heating element 52 is installed onto the second heat radiator 13 of the inverter heat-dissipation device 53 via the second opening arranged on the air channel 14 of the inverter heat-dissipation device 53.

In an embodiment, the first heating element 51 is installed onto a first heat radiator substrate via the first opening arranged on the air channel 14 of the inverter heat-dissipation device 53, and the first heat radiator substrate is a radiator substrate of the first heat radiator 12.

The second heating element 52 is installed onto a second heat radiator substrate via the second opening arranged on the air channel 14 of the inverter heat-dissipation device 53, and the second heat radiator substrate is a radiator substrate of the second heat radiator 13.

Further, a heat conduction silicone is coated on a contact surface between the first heating element 51 and the first heat radiator substrate; and a heat conduction silicone is coated on a contact surface between the second heating element 52 and the second heat radiator substrate.

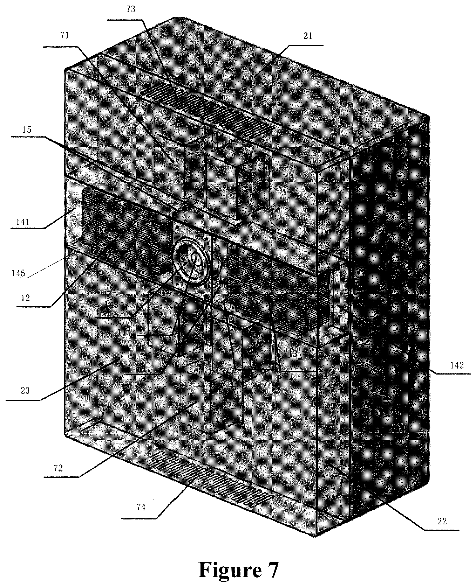

In an embodiment, a front-back box partition 23 of the inverter may function as the air channel backboard 144, as shown in Figure 6 or Figure 7.

In a case that the front-back box partition 23 functions as the air channel backboard 144, the centrifugal fan 11, the first heat radiator 12 and the second heat radiator 13 in the inverter heat-dissipation device shown in Figure 2 are arranged as follows.

The first heat radiator 12 and the second heat radiator 13 are installed fixedly at different points on the front-back box partition 23, and the centrifugal fan 11 is installed fixedly on the U-shaped groove 145.

The first heat radiator 12 fits on the front-back box partition 23 and is sealed, and the second heat radiator 13 fits on the front-back box partition 23 and is sealed, thereby ensuring that a front box has a sealing performance with a high IP class (greater than or equal to IP65).

In an embodiment, openings with respective sizes are arranged on the front-back box partition 23, for installing the first heating element 51 onto the first heat radiator 12 and installing the heating element 52 onto the second heat radiator 13.

The first heating element 51 and the second heating element 52 are arranged in a front box 21, and the inverter heat-dissipation device 53 is arranged in a back box 22.

The back box 22 is an open box, and other elements and members than the inverter heat-dissipation device 53 may also be placed on the back box 22, for example an electrical element and member, such as an inductor, a transformer, a fan and a pegboard. It should be noted that, the electrical elements, such as the inductor and the transformer, need to be filled and sealed or processed in other ways, so as to meet an IP class requirement for exposing to the atmospheric environment.

As shown in Figure 7, the inverter according to the present disclosure may further include a third heating element 71 and a fourth heating element 72.

The third heating element 71 is arranged above the third air outlet 15 in the inverter heat-dissipation device.

The fourth heating element 72 is arranged below the fourth air outlet 16 in the inverter heat-dissipation device.

The number of the third heating elements 71 may be greater than or equal to one.

The number of the fourth heating elements 72 may be greater than or equal to one.

Accordingly, the inverter may further include a first row of air vents 73 facing the third heating element 71 and a second row of air vents 74 facing the fourth heating element 72.

The third heating element 71 and the fourth heating element 72 dissipate heat through their surfaces without a heat radiator. The third heating element 71 discharges hot air and dissipates heat via the third air outlet 15, and the fourth heating element 72 discharges hot air and dissipates heat through the fourth air outlet 16. Hot air generated due to heat-dissipation of the third heating element 71 is discharged to the external atmospheric environment via the first row of air vents 73, and hot air generated due to heat-dissipation of the fourth heating element 72 is discharged to the external atmospheric environment via the second row of air vents 74.

It should be noted that, in the present specification, the embodiments are described in progressive manner. Each embodiment mainly focuses on an aspect difference from other embodiments, and reference can be made to these similar parts among the embodiments. The device disclosed in the embodiment corresponds to the method disclosed in the embodiment, and is described relatively simply. For detailed description of the device, reference may be made to the related description of the method.

Finally, it should be further noted that the relationship terminologies such as "first", "second" and the like are only used herein to distinguish one entity or operation from another, rather than to necessitate or imply that the actual relationship or order exists between the entities or operations. Furthermore, terms of "include", "comprise" or any other variants are intended to be non-exclusive. Therefore, a process, method, article or device including a plurality of elements includes not only the elements but also other elements that are not enumerated, or also include the elements inherent for the process, method, article or device. Unless expressively limited otherwise, the statement "comprising (including) one..." does not exclude the case that other similar elements may exist in the process, method, article or device.

The inverter heat-dissipation device and the inverter according to the present disclosure are described in detail above. The principles and implements are clarified using specific embodiments herein. The above description of the embodiments is only intended to help understanding the method of the present disclosure and the key concept thereof. In addition, changes can be made to the specific embodiments and the application scope by those skilled in the art based on the concept of the present disclosure. In summary, the specification should not be interpreted as limitation to the present disclosure.

## Claims

1. An inverter heat-dissipation device, comprising a centrifugal fan (11), a first heat radiator (12), a second heat radiator (13) and an air channel (14), wherein
a first air outlet (141) is arranged at one end of the air channel (14) and a second air outlet (142) is arranged at the other end of the air channel (14);
the first heat radiator (12) is arranged inside the air channel (14) and is in communication with the first air outlet (141);
the second heat radiator (13) is arranged inside the air channel (14) and is in communication with the second air outlet (142);
the centrifugal fan (11) is arranged inside the air channel (14) and is arranged between the first heat radiator (12) and the second heat radiator (13);
an air inlet (143) matching the centrifugal fan (11) in size is arranged on the air channel (14);
a first opening is arranged on the air channel (14), wherein a first heating element of an inverter comprising the inverter heat-dissipation device is installed onto the first heat radiator (12) through the first opening; and
a second opening is arranged on the air channel (14), wherein a second heating element of the inverter comprising the inverter heat-dissipation device is installed onto the second heat radiator (13) through the second opening.

2. The inverter heat-dissipation device according to claim 1, wherein the air channel (14) comprises an air channel backboard (144) and a U-shaped groove (145), and the air channel backboard (144) is installed onto the U-shaped groove (145).

3. The inverter heat-dissipation device according to claim 2, wherein
the first heat radiator (12) and the second heat radiator (13) are installed fixedly at different points on the air channel backboard (144); and
the centrifugal fan (11) is installed fixedly on the U-shaped groove (145).

4. The inverter heat-dissipation device according to any one of claims 1 to 3, further comprising:
a third air outlet (15) and a fourth air outlet (16), wherein
the third air outlet (15) is arranged on a first lateral surface of the air channel (14) and matches the centrifugal fan (11) in size; and
the fourth air outlet (16) is arranged on a second lateral surface of the air channel (14) opposite to the first lateral surface and matches the centrifugal fan (11) in size.

5. An inverter, comprising a first heating element (51), a second heating element (52) and the inverter heat-dissipation device (53) according to any one of claims 1 to 4, wherein
the first heating element (51) is installed onto the first heat radiator of the inverter heat-dissipation device (53) via the first opening arranged on the air channel (14) of the inverter heat-dissipation device (53); and
the second heating element (52) is installed onto the second heat radiator of the inverter heat-dissipation device (53) via the second opening arranged on the air channel (14) of the inverter heat-dissipation device (53).

6. The inverter according to claim 5, wherein
the first heating element (51) is installed onto a first heat radiator substrate via the first opening arranged on the air channel (14) of the inverter heat-dissipation device (53), wherein the first heat radiator substrate is a heat radiator substrate of the first heat radiator (12); and
the second heating element (52) is installed onto a second heat radiator substrate via the second opening arranged on the air channel (14) of the inverter heat-dissipation device (53), wherein the second heat radiator substrate is a heat radiator substrate of the second heat radiator (13).

7. The inverter according to claim 6, wherein
a heat conduction silicone is coated on a contact surface between the first heating element (51) and the first heat radiator substrate; and
a heat conduction silicone is coated on a contact surface between the second heating element (52) and the second heat radiator substrate.

8. The inverter according to claim 6, further comprising:
a third heating element (71) and a fourth heating element (72), wherein
the third heating element (71) is arranged above the third air outlet (15) of the inverter heat-dissipation device; and
the fourth heating element (72) is arranged below the fourth air outlet (16) of the inverter heat-dissipation device.

9. The inverter according to claim 8, further comprising:
a first row of air vents (73) facing the third heating element (71); and
a second row of air vents (74) facing the fourth heating element (72).

## Patentansprüche

1. Wechselrichter-Wärmeabführungsvorrichtung, die einen Zentrifugalventilator (11), einen ersten Wärmestrahler (12), einen zweiten Wärmestrahler (13) und einen Luftkanal (14) aufweist, wobei
ein erster Luftauslass (141) an einem Ende des Luftkanals (14) angeordnet ist und ein zweiter Luftauslass (142) an dem anderen Ende des Luftkanals (14) angeordnet ist;
der erste Wärmestrahler (12) im Inneren des Luftkanals (14) angeordnet ist und in Verbindung mit dem ersten Luftauslass (141) steht;
der zweite Wärmestrahler (13) im Inneren des Luftkanals (14) angeordnet ist und in Verbindung mit dem zweiten Luftauslass (142) steht;
der Zentrifugalventilator (11) im Inneren des Luftkanals (14) angeordnet ist und zwischen dem ersten Wärmestrahler (12) und dem zweiten Wärmestrahler (13) angeordnet ist;
ein Lufteinlass (143), dessen Größe zu dem Zentrifugalventilator (11) passt, auf dem Luftkanal (14) angeordnet ist;
eine erste Öffnung auf dem Luftkanal (14) angeordnet ist, wobei ein erstes Heizelement eines Wechselrichters, der die Wechselrichter-Wärmeabführungsvorrichtung aufweist, durch die erste Öffnung auf dem ersten Wärmestrahler (12) installiert ist; und
eine zweite Öffnung auf dem Luftkanal (14) angeordnet ist, wobei ein zweites Heizelement des Wechselrichters, der die Wechselrichter-Wärmeabführungsvorrichtung aufweist, durch die zweite Öffnung auf dem zweiten Wärmestrahler (12) installiert ist.

2. Wechselrichter-Wärmeabführungsvorrichtung nach Anspruch 1, wobei der Luftkanal eine Luftkanalrückwand (144) und eine U-förmige Nut (145) aufweist, und wobei die Luftkanalrückwand (144) auf der U-förmigen Nut (145) installiert ist.

3. Wechselrichter-Wärmeabführungsvorrichtung nach Anspruch 2, wobei der erste Wärmestrahler (12) und der zweite Wärmestrahler (13) fest an verschiedenen Punkten auf der Luftkanalrückwand (144) installiert sind; und der Zentrifugalventilator (11) fest auf der U-förmigen Nut (145) installiert ist.

4. Wechselrichter-Wärmeabführungsvorrichtung nach einem der Ansprüche 1 bis 3, die ferner aufweist:
einen dritten Luftauslass (15) und einen vierten Luftauslass (16), wobei der dritte Luftauslass (15) auf einer ersten seitlichen Oberfläche des Luftkanals (14) angeordnet ist und seine Größe zu dem Zentrifugalventilator (11) passt; und
der vierte Luftauslass (16) auf einer zweiten seitlichen Oberfläche des Luftkanals (14) angeordnet ist und seine Größe zu dem Zentrifugalventilator (11) passt.

5. Wechselrichter, der ein erstes Heizelement (51), ein zweites Heizelement (52) und die Wechselrichter-Wärmeabführungsvorrichtung (53) nach einem der Ansprüche 1 bis 4 aufweist, wobei
das erste Heizelement (51) über die erste Öffnung, die auf dem Luftkanal (14) der Wechselrichter-Wärmeabführungsvorrichtung (53) angeordnet ist, auf dem ersten Wärmestrahler der Wechselrichter-Wärmeabführungsvorrichtung (53) installiert ist; und
das zweite Heizelement (52) über die zweite Öffnung, die auf dem Luftkanal (14) der Wechselrichter-Wärmeabführungsvorrichtung (53) angeordnet ist, auf dem zweiten Wärmestrahler der Wechselrichter-Wärmeabführungsvorrichtung (53) installiert ist.

6. Wechselrichter nach Anspruch 5, wobei
das erste Heizelement (51) über die erste Öffnung, die auf dem Luftkanal (14) der Wechselrichter-Wärmeabführungsvorrichtung (53) angeordnet ist, auf einem ersten Wärmestrahlersubstrat installiert ist, wobei das erste Wärmestrahlersubstrat ein Wärmestrahlersubstrat des ersten Wärmestrahlers (12) ist; und
das zweite Heizelement (52) über die zweite Öffnung, die auf dem Luftkanal (14) der Wechselrichter-Wärmeabführungsvorrichtung (53) angeordnet ist, auf einem zweiten Wärmestrahlersubstrat installiert ist, wobei das zweite Wärmestrahlersubstrat ein Wärmestrahlersubstrat des zweiten Wärmestrahlers (13) ist.

7. Wechselrichter nach Anspruch 6, wobei
ein Wärmeleitungssilikon auf eine Kontaktoberfläche zwischen dem ersten Heizelement (51) und dem ersten Wärmestrahlersubstrat beschichtet ist; und ein Wärmeleitungssilikon auf eine Kontaktoberfläche zwischen dem zweiten Heizelement (52) und dem ersten Wärmestrahlersubstrat beschichtet ist.

8. Wechselrichter nach Anspruch 6, der ferner aufweist:
ein drittes Heizelement (71) und ein viertes Heizelement (72), wobei das dritte Heizelement (71) über dem dritten Luftauslass (15) der Wechselrichter-Wärmeabführungsvorrichtung angeordnet ist; und
das vierte Heizelement (72) unter dem vierten Luftauslass (16) der Wechselrichter-Wärmeabführungsvorrichtung angeordnet ist.

9. Wechselrichter nach Anspruch 8, der ferner aufweist:
eine erste Reihe von Entlüftungsöffnungen (73), die dem dritten Heizelement (71) zugewandt sind; und
eine zweite Reihe von Entlüftungsöffnungen (74), die dem vierten Heizelement (72) zugewandt sind.

## Revendications

1. Dispositif de dissipation de chaleur d'onduleur, comprenant un ventilateur centrifuge (11), un premier radiateur thermique (12), un deuxième radiateur thermique (13) et un canal d'air (14), dans lequel :
une première sortie d'air (141) est agencée à une extrémité du canal d'air (14) et une deuxième sortie d'air (142) est agencée à l'autre extrémité du canal d'air (14) ;
le premier radiateur thermique (12) est agencé à l'intérieur du canal d'air (14) et est en communication avec la première sortie d'air (141) ;
le deuxième radiateur thermique (13) est agencé à l'intérieur du canal d'air (14) et est en communication avec la deuxième sortie d'air (142) ;
le ventilateur centrifuge (11) est agencé à l'intérieur du canal d'air (14) et est agencé entre le premier radiateur thermique (12) et le deuxième radiateur thermique (13) ;
une entrée d'air (143) correspondant à la taille du ventilateur centrifuge (11) est agencée sur le canal d'air (14) ;
une première ouverture est agencée sur le canal d'air (14), dans lequel un premier élément chauffant d'un onduleur comprenant le dispositif de dissipation de chaleur d'onduleur est installé sur le premier radiateur thermique (12) par la première ouverture ; et
une deuxième ouverture est agencée sur le canal d'air (14), dans lequel un deuxième élément chauffant de l'onduleur comprenant le dispositif de dissipation de chaleur d'onduleur est installé sur le deuxième radiateur thermique (13) par la deuxième ouverture.

2. Dispositif de dissipation de chaleur d'onduleur selon la revendication 1, dans lequel le canal d'air (14) comprend un panneau de canal d'air (144) et une rainure en forme de U (145), et le panneau de canal d'air (144) est installé sur la rainure en forme de U (145).

3. Dispositif de dissipation de chaleur d'onduleur selon la revendication 2, dans lequel :
le premier radiateur thermique (12) et le deuxième radiateur thermique (13) sont installés, de manière fixe, à différents points sur la plaque de canal d'air (144) ; et
le ventilateur centrifuge (11) est installé, de manière fixe, sur la rainure en forme de U (145).

4. Dispositif de dissipation de chaleur d'onduleur selon l'une quelconque des revendications 1 à 3, comprenant en outre :
une troisième sortie d'air (15) et une quatrième sortie d'air (16), dans lequel :
la troisième sortie d'air (15) est agencée sur une première surface latérale du canal d'air (14) et correspond à la taille du ventilateur centrifuge (11) ; et
la quatrième sortie d'air (16) est agencée sur une deuxième surface latérale du canal d'air (14) opposée à la première surface latérale et correspond à la taille du ventilateur centrifuge (11).

5. Onduleur comprenant un premier élément chauffant (51), un deuxième élément chauffant (52) et le dispositif de dissipation de chaleur d'onduleur (53) selon l'une quelconque des revendications 1 à 4, dans lequel :
le premier élément chauffant (51) est installé sur le premier radiateur thermique du dispositif de dissipation de chaleur d'onduleur (53) via la première ouverture agencée sur le canal d'air (14) du dispositif de dissipation de chaleur d'onduleur (53) ; et
le deuxième élément chauffant (52) est installé sur le deuxième radiateur thermique du dispositif de dissipation de chaleur d'onduleur (53) via la deuxième ouverture agencée sur le canal d'air (14) du dispositif de dissipation de chaleur d'onduleur (53).

6. Onduleur selon la revendication 5, dans lequel :
le premier élément chauffant (51) est installé sur un premier substrat de radiateur thermique via la première ouverture agencée sur le canal d'air (14) du dispositif de dissipation de chaleur d'onduleur (53), dans lequel le premier substrat de radiateur thermique est un substrat de radiateur thermique du premier radiateur thermique (12) ; et
le deuxième élément chauffant (52) est installé sur un deuxième substrat de radiateur thermique via la deuxième ouverture agencée sur le canal d'air (14) du dispositif de dissipation de chaleur d'onduleur (53), dans lequel le deuxième substrat de radiateur thermique est un substrat de radiateur thermique du deuxième radiateur thermique (13).

7. Onduleur selon la revendication 6, dans lequel :
une silicone de conduction de chaleur est appliquée sur une surface de contact entre le premier élément chauffant (51) et le premier substrat de radiateur thermique ; et
une silicone de conduction de chaleur est appliquée sur une surface de contact entre le deuxième élément chauffant (52) et le deuxième substrat de radiateur thermique.

8. Onduleur selon la revendication 6, comprenant en outre :
un troisième élément chauffant (71) et un quatrième élément chauffant (72), dans lequel :
le troisième élément chauffant (71) est agencé au-dessus de la troisième sortie d'air (15) du dispositif de dissipation de chaleur d'onduleur ; et
le quatrième élément chauffant (72) est agencé au-dessus de la quatrième sortie d'air (16) du dispositif de dissipation de chaleur d'onduleur.

9. Onduleur selon la revendication 8, comprenant en outre :
une première rangée d'évents d'air (73) faisant face au troisième élément chauffant (71) ; et
une deuxième rangée d'évents d'air (74) faisant face au quatrième élément chauffant (72).
